Europäisches Patentamt

European Patent Office

Office européen des brevets

(11) Publication number: **0 408 765 A1**

# EUROPEAN PATENT APPLICATION
## published in accordance with Art. 158(3) EPC

(21) Application number: 90901897.0

(22) Date of filing: 17.01.90

(86) International application number:
PCT/JP90/00051

(87) International publication number:
WO 90/08998 (09.08.90 90/19)

(51) Int. Cl.5: **G06F 3/023**

(30) Priority: 03.02.89 JP 26431/89

(43) Date of publication of application:
**23.01.91 Bulletin 91/04**

(84) Designated Contracting States:
**DE FR GB**

(71) Applicant: **FANUC LTD.**
**3580, Shibokusa Aza-Komanba, Oshino-mura**
**Minamitsuru-gun, Yamanashi 401-05(JP)**

(72) Inventor: **YONEKURA, Mikio**
**KeioTakaoMansion 1103**
**1231-36, Hatsusawamachi Hachioji-shi**
**Tokyo 193(JP)**

(74) Representative: **Brunner, Michael John et al**
**GILL JENNINGS & EVERY 53-64 Chancery**
**Laneane**
**London WC2A 1HN(GB)**

(54) MATRIX CONTROLLER.

(57) A matrix controller for recognizing the conditions of a plurality of switches. The switches are arranged at the intersecting points 1F (ME11 to ME44) of a matrix, two per point, and are provided with sets of diodes for preventing the run-around. Each of the sets comprises four diodes, with the two diodes opposite to the others. There are provided with first drivers (CDV1 to CDV4) for driving columns (COL1 to COL4) of the matrix at the high or low level, second drivers (RDV1 to RDV4) for driving rows (ROW1 to ROW4) of the matrix at the high or low level, and receivers (RV1 to RV4) which are connected to the rows of the matrix to recognize the conditions. Each of the columns (COL1 to COL4) of the matrix comprises two lines, each connected to a couple of the diodes, for example, one line of the column (COL1) connected to the diodes (D1al and D1a2) and the other connected to the diodes (D1b1 and D1b2). The two couples in each column are parallel but opposite in polarity. The tail of one couple of the diodes and the head of the other in each column are connected to the corresponding first driver through a line. For recognition of the conditions, the levels of the first drivers (CDV1 to CDV4) and the second drivers (RDV1 to RDV4) are made reverse to each other. Thus, the number of switches whose conditions are recognized are twice that of conventional techniques with the same number of the interface lines. Further, the recognition of and the dynamic display by LEDs are effected through the same matrix. Switching of the LEDs is controlled excepting the time when the conditions are recognized.

Xerox Copy Centre

FIG. 1

D E S C R I P T I O N

MATRIX CONTROL CIRCUIT

Technical Field

The present invention relates to a matrix control circuit used in a keyboard or the like of a control device, such as a numerical control device, and more particularly, to a matrix circuit having a reduced number of interface signal lines.

Background Art

As is generally known, a keyboard used in a conventional control device or the like uses a system (key matrix system) in which key switch elements are arranged in the form of a matrix so that the position of a depressed key can be detected by sensing the state of row lines by receivers when one column is driven for a low-level output by transistors.

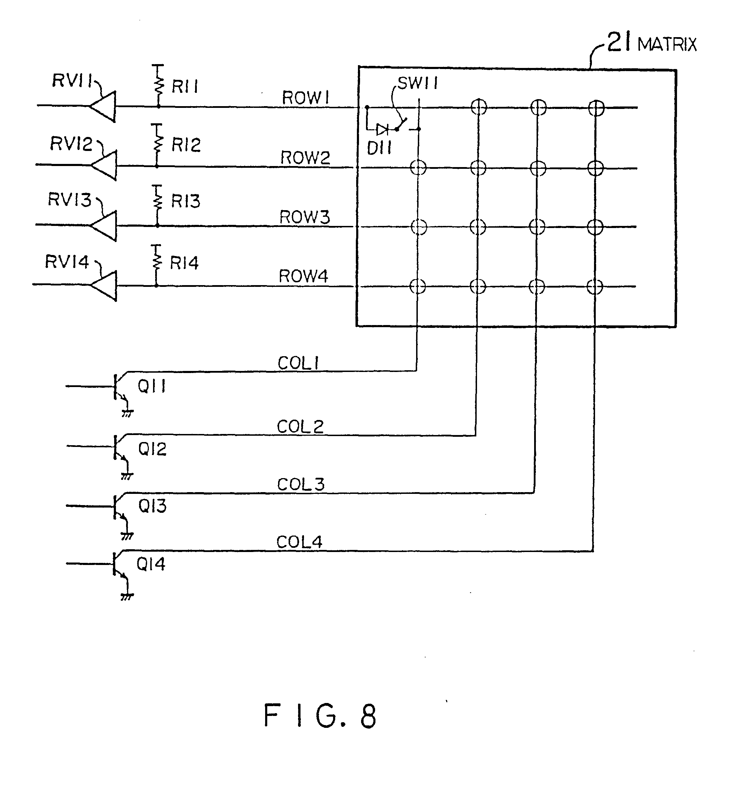

Figure 8 is a diagram showing an arrangement of a prior art key matrix system. Four transistors Q11 to Q14 drive column lines COL1 to COL4 of a matrix 21, respectively, and the state of switches in the matrix 21 is read from row lines ROW1 to ROW4 by four receivers RV11 to RV14. A node of a column line and a row line of the matrix 21 is connected to a switch SW11 by a sneak current-preventing diode D11. Note, in Fig. 8, only the switch and diode at one node of the matrix are illustrated, and the switches and diodes at the other nodes, which are arranged in the same manner, are omitted. Further, R11 to R14 designate pull-up resistors.

Furthermore, when driving LED's for a dynamic display, the LED's are arranged in place of the switches and diodes shown in Fig. 8, the column lines COL1 to COL4 are individually driven, and signals for turning on the LED's are supplied to the row lines ROW1 to ROW4.

In the conventional system, if the number of keys or LED's is increased, the number of signal lines is correspondingly increased, and accordingly, the number of connector pins and cable cores is increased, and thus the costs are increased. Also, an increase in the number lines lowers the efficiency of wiring operation.

In personal computers and the like, the problem of the increase in the number of signal lines is avoided by providing a microprocessor on the keyboard side and connected to the control device body by a serial interface.

This system, however, increases the number of circuits in the keyboard, and therefore, is not economical. Further, taking into consideration the power supply and a maintenance of the reliability of data communication, the distance between the control device body and the keyboard is limited, and thus this system is not always the best method for devices such as numerical control devices, in which the keyboard is often separated from the control device body.

Disclosure of the Invention

The present invention has been created in consideration of these circumstances, and a first object of the present invention is to provide a matrix control circuit in which the states of a number of switches can be recognized while using fewer interface lines.

A second object of the present invention is to provide a matrix control circuit in which a number of LED's can be turned on while using fewer interface lines.

A third object of the present invention is to provide a matrix control circuit in which switches and LED's are arranged on one and the same matrix so that the recognition of the states of the switches and the lighting of the LED's can be controlled from the same matrix.

To solve the above problems, according to the present invention, there is provided a matrix control circuit for recognizing the states of a plurality of switches, in which the matrix control circuit comprises switches arranged in pairs at each node of a matrix and each having sneak current-preventing diodes connected in opposite directions, a first drive circuit for driving each column of the matrix for a high- or low-level output, a second drive circuit for driving each row of the matrix for a high- or low-level output, and a receiver circuit connected to each row of the matrix and adapted to recognize the states of the switches, each column of the matrix being composed of two lines and having diodes connected in parallel with and in opposite directions to each other so that the side of the diodes opposite to the matrix is connected to one line and the first drive circuit, the levels of the first drive circuit and the second drive circuit being made opposite to produce a bi-directional drive current when the switch state is recognized.

Further, there is provided a matrix control circuit for effecting a dynamic display of LED's (light emitting diodes), in which the matrix control circuit comprises LED's arranged in pairs at a node of each matrix and having an opposite polarity, a first drive circuit for driving each column of the matrix for a high- or low-level output, and a second drive circuit for driving each row of the matrix for a high- or low-level output, each column of the matrix being composed of two lines and having diodes connected in parallel with and in opposite directions to each other so that the side of the diodes opposite to the matrix is connected to one line and the first drive circuit, the levels of the first drive circuit and the second drive circuit being made opposite to produce a bi-directional driving current when the LED's are turned on.

Furthermore, there is provided a matrix control circuit for recognizing the states of a plurality of switches and effecting a dynamic display of LED's (light emitting diodes), in which the matrix control circuit comprises switches arranged in pairs at a node of each matrix and each having a sneak current-preventing diode, an LED disposed at the node, a first drive circuit for driving each column of the matrix for a high- or low-level output, a second drive circuit for driving each row of the matrix for a high- or low-level output, and a receiver circuit connected to each row of the matrix and adapted to recognize the states of the switches, each column of the matrix being composed of two lines and having diodes connected in parallel with and in opposite directions to each other so that the side of the diodes opposite to the matrix is connected to one line and the first drive circuit, the levels of the first drive circuit and the second drive circuit being made opposite to produce a bi-directional driving current when the switch state is recognized or when the LED's are turned on.

The column lines of the matrix are arranged in two sets, the switches are connected between the individual lines and row lines, the diodes are reversely connected to the two sets of lines, and one of the lines is connected to the first drive circuit. The state of one of the two switches is recognized by activating the first and second drive circuits for driving the columns and the rows, respectively, to the low and high levels, respectively.

Accordingly, the state of the other switch is recognized by activating the first and second drive circuits for driving the columns and the rows of the matrix, respectively, to the high and low levels, respectively.

Namely, the states of twice as many switches can be recognized while using the same number of interface lines.

Further, the dynamic display of the LED's is effected by a substantially similar matrix control circuit, so that twice as many LED's can be turned on while using the same number of interface lines as in the conventional device.

Furthermore, the recognition of the switch states and the dynamic display of the LED's are effected from the same matrix, and the circuitry is arranged such that the lighting control of the LED's is effected at a time other than the time at which the states of the switches are recognized.

Brief Description of the Drawings

Fig. 1 is a diagram showing an arrangement of one embodiment of a matrix control circuit according to the present invention;

Fig. 2(a) is a diagram showing a case in which a matrix element is formed of two switches;

Fig. 2(b) is a diagram showing a case in which the matrix element is formed of one switch and one LED;

Fig. 2(c) is a diagram showing a case in which the matrix element is formed of one switch and one LED;

Fig. 2(d) is a diagram showing a case in which the matrix element is formed of two LED's;

Fig. 3 is a diagram showing an interface of a drive circuit;

Fig. 4 is a diagram showing an example in which the drive circuit is formed of transistors;

Fig. 5 is a diagram showing an example in which the drive circuit is formed of enhancement MOS's;

Fig. 6 is a diagram illustrating sneak current prevention;

Fig. 7 is an equivalent circuit diagram of Fig. 6; and

Fig. 8 is a diagram showing an arrangement of a prior art key matrix system.

Best Mode of Carrying Out the Invention

One embodiment of the present invention will now be described with reference to the drawings.

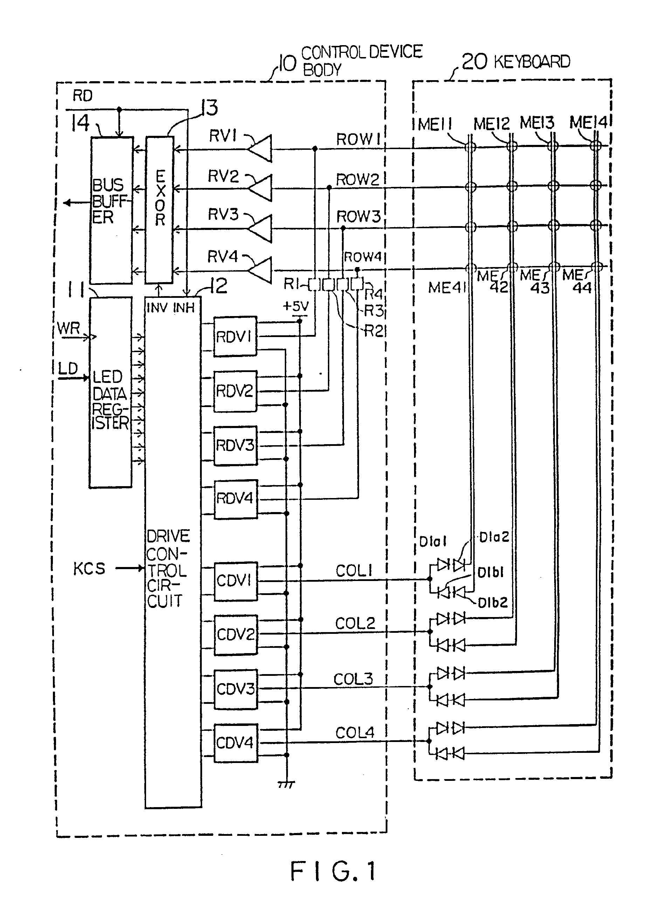

Figure 1 shows an arrangement of one embodiment of a matrix control circuit according to the present invention. In the present embodiment, a keyboard 20 has a 4-by-4 matrix configuration, and 16 matrix elements ME11 to ME44 are connected to nodes of row lines ROW1 to ROW4 and column lines COL1 to COL4.

The construction of each matrix element will now be described.

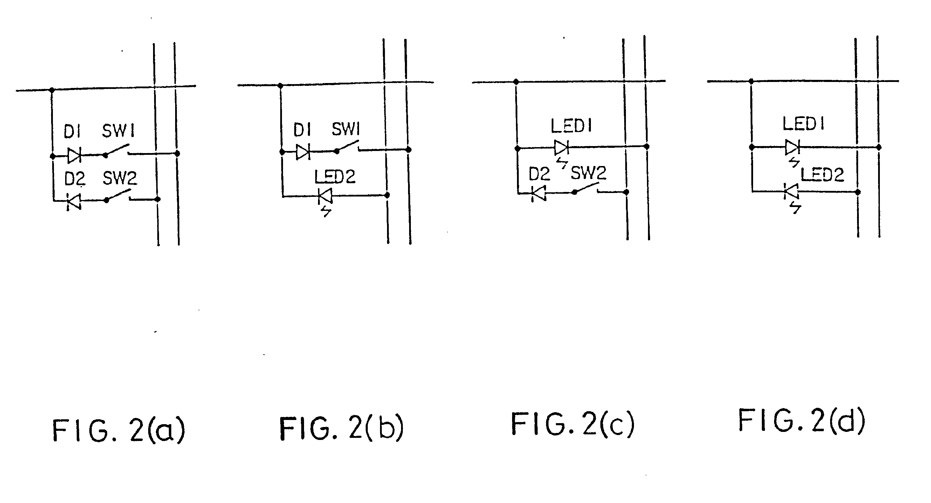

Figure 2(a) shows a case in which the matrix element is composed of two switches. As shown in the figure, two column lines, and sneak current-preventing diodes D1 and D2 are reversely connected to switches SW1 and SW2, respectively, which are connected to corresponding column lines.

Figure 2(b) shows a case in which the matrix element is composed of a switch and an LED. As shown in the figure, a sneak current-preventing diode D1 connected to a switch SW1, and LED2 have opposite polarities and are connected to corresponding column lines.

Figure 2(c) shows a case in which the matrix element is composed of a switch and an LED. This arrangement differs from that shown in Fig. 2(b) only in the positioning of the LED and the diode.

Figure 2(d) shows a case in which the matrix element is composed of two LED's, LED1 and LED2, having opposite polarities and connected to corresponding column lines.

In the present invention, as seen from Figs. 2(a) to 2(d), the row and column lines of the matrix are composed of two sets of lines; in the prior art, these lines are only interface signal lines led from the body of a control device. In the present invention, however, the two diodes are reversely connected to corresponding lines, which are each divided into two lines depending on the direction of electric current.

This system, due to the diode D1 interposed in series with the switch SW1, solves the problem of a misunderstanding of the key state attributable to a so-called sneak current which occurs when three or more key switches are simultaneously depressed. This prevention of the sneak current will be described in detail later.

Returning to Fig. 1, at an interface on the side of the control device body 10, row drive circuits RDV1 to RDV4 are connected to the individual row lines ROW1 to ROW4 through receivers RV1 to RV4 and resistors R1 to R4, respectively. Also, column drivers CDV1 to CDV4 are connected directly to the individual column lines COL1 to COL4, respectively.

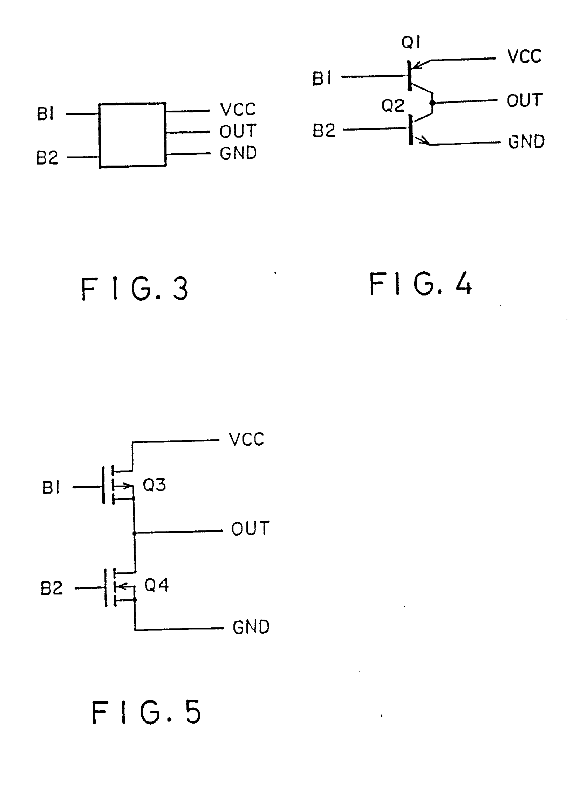

The aforesaid drive circuit will now be described in detail. Figure 3 shows an interface of the drive circuit, which is the interface for each of the drive circuits CDV1 to CDV4 and RDV1 to RDV4 of Fig. 1.

Figure 4 is a diagram showing an example in which the drive circuit is formed of transistors. The transistors Q1 and Q2 are connected in a complementary manner, and thus if inputs B1 and B2 become low level, an output OUT becomes high level. Conversely, if the inputs B1 and B2 become high level, the output OUT becomes low level.

Figure 5 shows an example in which the drive circuit is formed of enhancement MOS's. As shown in Fig. 5, p- and n-type enhancement MOS's are connected in a complementary manner, and thus the relationships between the inputs and output are the same as in the case of the transistor-based arrangement of Fig. 4.

Returning again to Fig. 1, as described above, the row and column drive circuits are each composed of two transistors and can be driven for high level outputs (+5 V) or low level outputs (GND) in response to a signal from the drive control circuit 12.

The receivers RV1 to RV4 determine the output level, i.e., high or low, of the row lines ROW1 to ROW4 on the basis of a given threshold level, e.g., 2.5 V, and deliver a logic signal indicating the output level. The receivers RV1 to RV4 are individually connected to an exclusive OR gate 13, and the output signals thereof are connected through the exclusive OR gate 13 to a bus of a processor, by a bus buffer 14.

The exclusive OR gate 13 is adapted to deliver the outputs of the receivers without change when a control signal INV from the drive control circuit is 0, and to deliver inverted versions of the outputs of the receivers when the INV is 1.

The drive control circuit 12 receives display data written to an LED data register 11 by the processor and desired key selection signals to be read by the processor, as inputs, and controls the drive circuits RDV1 to RDV4 and CDV1 to CDV4 in response to the inputs.

The following is a description of a first case in which the processor reads the key state. This operation is performed in a manner such that the column lines COL1 to COL4 of the matrix are driven in response to the key selection signals from the processor while key read pulses RD are received from the processor, as in the case of the conventional matrix-type interface. According to the present embodiment, there are a total of eight ways in which this driving can be carried out, based on the combination of the output levels, high or low, and the four column lines COL1 to COL4 to be driven. The column lines which are not driven are in an open state (high-impedance state).

Regarding the row lines ROW1 to ROW4, all of the row lines ROW1 to ROW4 are pulled up or down by the resistors R1 to R4, by causing all of the row drivers to deliver high- or low-level outputs. The alternativity depends on the level of the column lines COL1 to COL4. Namely, if the column lines COL1 to COL4 are driven for low-level outputs, the row lines ROW1 to ROW4 are pulled up, and if the column lines COL1 to COL4 are driven for high-level outputs, the row lines ROW1 to ROW4 are pulled down.

The following is a description of a case in which the row lines ROW1 to ROW4 are pulled up, and the column lines COL1 to COL4 are driven for low-level outputs. It is understood that the row lines are individually driven to the low level, and the key state for each row is correspondingly recognized.

While a key is depressed, current flows from a pull-up resistor of the row line to which the key is connected to the column drive circuits CDV1 to CDV4, through the key, so that the inputs of the receivers RV1 to RV4 become low level and 0 appears at the receiver outputs. In this case, the signal INV is 1, and the processor can read a logical 1 through the bus buffer 14.

The following is a case in which the rows are pulled down, and the columns are driven for high-level outputs. Also in this case, the column lines are individually driven, and the receivers recognize the key state for each row.

While a key is depressed, current flows from the column driver to which the key is connected to a pull-down resistor of the column line through the key, and thus the receiver inputs become high level and 1 appears at the receiver outputs.

In this case, the signal INV is 0, and the processor can read a logical 1 through the bus buffer 14. More specifically, the signal INV changes in accordance with the outputs of the column drive circuits and the row drive circuits, and thus the processor always can read the key state as a positive logic.

The LED display control will now be described. The processor writes data to assign desired LED's to be turned on in the LED data register 11, and based on this data, the drive control circuit drives the LED's during the time in which the aforesaid key reading operation is not performed. In practice, the LED's are always driven for a dynamic display, and the key reading is executed at a fixed period. The basic drive method is the conventional dynamic drive system, but the present invention is characterized in that the key reading is executed during the spare time in which the dynamic display of the LED's is not effected, and thus the LED's can be driven by using only the signal lines ROW1 to ROW4 and COL1 to COL4 used for the key reading, and therefore, the use of an exclusive-use signal line for the LED lighting is not required.

More specifically, the matrix of the LED's is always driven except during the time when the RD signal is applied to the input INV of the drive control circuit 12, as in Fig. 1. Therefore, by successively driving the column lines COL1 to COL4 for high- and low-level outputs at each given period of time, one column of the matrix is selected, and only those row lines which carry the LED's to be turned on, among the LED's connected to the selected column, are given a polarity such that current is made to flow through the LED's by the row drivers RDV1 to RDV4.

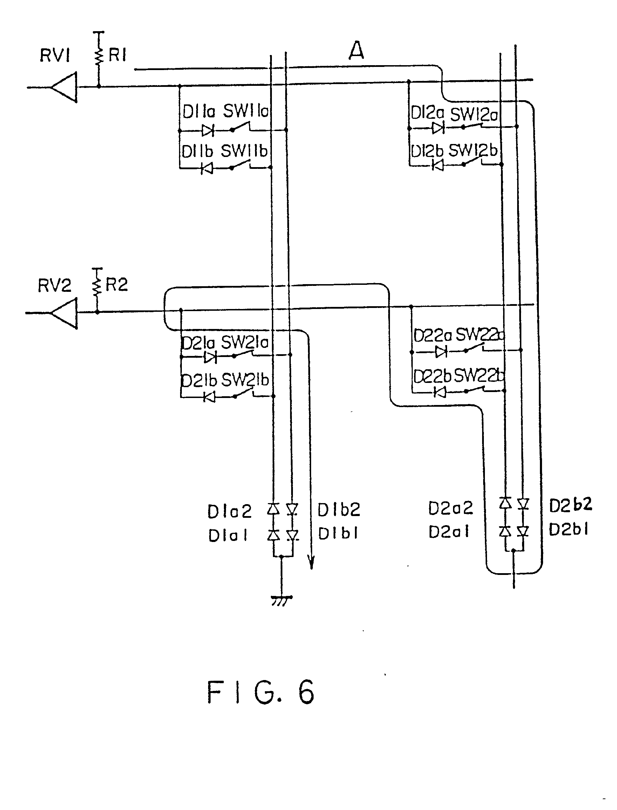

The following is a description of the sneak current-preventing function of the present invention. Fig. 6 is a diagram illustrating this sneak current prevention, and shows a case in which the column line COL1 is driven for a low-level output to recognize keys for one column. Here it is assumed that a key SW11a of the first row to be read is off, and keys SW12a and SW22b of the second column are on. As seen from Fig. 6, it mistakenly appears that the current flows through the resistor R1 in a loop indicated by arrow A, and thus the input of the receiver RV1 is low level and the key SW11a is on. As mentioned later, however, such a sneak current can be prevented by diodes interposingly connected to the column lines.

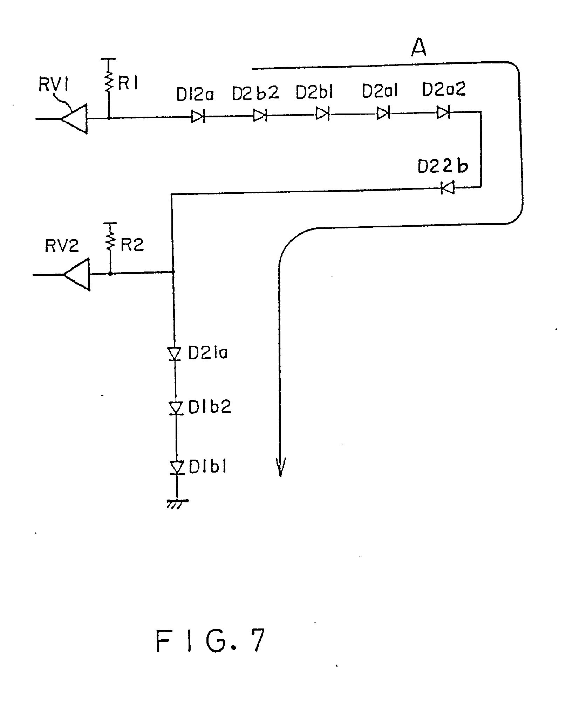

Figure 7 is an equivalent circuit diagram of Fig. 6, except that the keys of Fig. 6 are omitted from this drawing. In this arrangement, current from the resistor R1 flows in series to nine diodes, as illustrated. Therefore, if the forward voltage drop of one diode is 0.5 V, the input level of the receiver RV1 is 4.5 V while the threshold voltage of the receiver RV1 is 2.5 V, and thus it cannot be mistakenly considered that the key SW11a is depressed. This sneak current-preventing mechanism is characterized in that a plurality of diodes are interposingly connected to the column lines in accordance with the direction of the current. These diodes serve to shift the voltage at the input ends of the receivers in the key reading operation. If the current flow is caused by a sneaking, the shift voltage is three times as high as that where the key is actually depressed. In the example of Fig. 6, there are voltage shifts for two diodes D1b1 and D1b2 at the input end of the receiver RV2, but in the receiver RV1, there are voltage shifts for six diodes D2b2, D2b1, D2a1, D2a2, D1b2 and D1b1. Therefore, on balance, the voltage shifts for the four diodes enable a discrimination of the sneak current.

Such a sneak current-preventing function is also effected in the LED circuit, and thus the voltage applied to the LED's is so low that the LED's virtually are not turned on.

It is understood that the aforesaid value of the level shift voltage is an approximate value, and the number of diodes on the column lines must be actually selected in accordance with the level shift voltage of the diodes.

In the present embodiment, there are eight ways of driving the column lines, based on the product of four, the number of column lines, and two, the number of levels, so that the maximum number of LED's capable of being driven by means of this circuit is 32.

In the conventional system, only 16 keys can be provided where the total number of interface signal lines is eight, by combining the four row lines and the four column lines. Further, another signal line must be used to turn on the LED's. According to the present invention, however, any combination of a total of up to 32 keys or LED's can be provided while using the eight interface signal lines.

In the system of the present invention, the number of columns is equivalently doubled by making the current flowing through the matrix bi-directional. In fact, in the example of Fig. 1, the right-hand matrix is equivalent to a 4-row 8-column matrix, and thus a keyboard function double that of the conventional function can be controlled while using the same number of interface signal lines. Accordingly, the cables need not be made bulkier, and thus advantages in cost and ease of handling are gained.

As seen from Fig. 1, moreover, the drivers for the LED display can share hardware with switching circuits for the pull-up or pull-down resistors for the key reading and the column drivers. The arrangement has a smaller size and lower cost than the conventional arrangement in which exclusive-use hardware is provided for each of key arrangement and LED display.

Although the 4-by-4 matrix has been described above, these figures are given by way of example only, and any matrix configuration (n-by-m) may be used.

According to the present invention, as described above, the matrix includes two sets of column lines, and the matrix control circuit is arranged such that a bi-directional current flows through the matrix, and thus the states of twice as many switches can be recognized while using the same number of interface lines.

Since the dynamic display of the LED's is effected by a similar matrix control circuit, moreover, twice as many LED's as in the conventional device can be driven for the dynamic display, while using the same number of interface lines.

Further, the matrix control circuit is designed such that the recognition of the switch state and the dynamic display of the LED's are effected from the same matrix, and the lighting control of the LED's is effected at a time other than the time at which the states of the switches are recognized. Accordingly, the recognition of the switch states and the dynamic display of the LED's can be effected while using a simple circuit configuration, and as a result, the interface on the side of the control device body can be also made more compact than that of the conventional device.

CLAIMS

1. A matrix control circuit for recognizing states of a plurality of switches, the matrix control circuit comprising:

switches arranged in pairs at each node of a matrix and each having sneak current-preventing diodes connected in opposite directions;

a first drive circuit for driving each column of said matrix for a high- or low-level output;

a second drive circuit for driving each row of said matrix for a high- or low-level output; and

a receiver circuit connected to each row of said matrix and adapted to recognize the states of the ·switches,

each column of said matrix being composed of two lines and having diodes connected in parallel with and in opposite directions to each other so that the side of the diodes opposite to said matrix is connected to one line and said first drive circuit,

the levels of said first drive circuit and said second drive circuit being made opposite to produce a bi-directional driving current when recognizing the switch states.

2. A matrix control circuit according to claim 1, wherein said switches are key switches of a keyboard.

3. A matrix control circuit for effecting dynamic display of LED's (light emitting diodes), the matrix control circuit comprising:

LED's arranged in pairs at a node of each matrix and having opposite polarities;

a first drive circuit for driving each column of said matrix for a high- or low-level output; and

a second drive circuit for driving each row of said matrix for a high- or low-level output,

each column of said matrix being composed of two lines and having diodes connected in parallel with and in opposite directions to each other so that the side of the diodes opposite to said matrix is connected to one line and said first drive circuit,

the levels of said first drive circuit and said second drive circuit being made opposite to produce a bi-directional driving current when turning on said LED's.

4. A matrix control circuit for recognizing the states of a plurality of switches and effecting a dynamic display of LED's (light emitting diodes), the matrix control circuit comprising:

switches arranged in pairs at a node of each matrix and each having a sneak current-preventing diode;

an LED disposed at said node;

a first drive circuit for driving each column of said matrix for a high- or low-level output;

a second drive circuit for driving each row of said matrix for a high- or low-level output; and

a receiver circuit connected to each row of said matrix and adapted to recognize the states of the switches,

each column of said matrix being composed of two lines and having diodes connected in parallel with and in opposite directions to each other so that the side of the diodes opposite to said matrix is connected to one line and said first drive circuit,

the levels of said first drive circuit and said second drive circuit being made opposite to produce a bi-directional driving current when recognizing the switch states or turning on said LED's.

5. A matrix control circuit according to claim 4, wherein the node of said matrix is composed of two switches connected in opposite directions to each other.

6. A matrix control circuit according to claim 4, wherein the node of said matrix is composed of two LED's connected in opposite directions to each other.

7. A matrix control circuit according to claim 4, wherein the node of said matrix is composed of a switch connected in series with a sneak current-preventing diode and an LED.

8. A matrix control circuit according to claim 4, wherein an operation for turning on said LED's is executed at a time other than the time in which the states of said switches are recognized.

F I G.1

FIG. 2(a)  FIG. 2(b)  FIG. 2(c)  FIG. 2(d)

EP 0 408 765 A1

BI — [ ] — VCC
        — OUT
B2 — [ ] — GND

# F I G. 3

Q1
BI — — VCC
Q2
     — OUT
B2 — — GND

# F I G. 4

— VCC
BI — Q3
     — OUT
B2 — Q4
     — GND

# F I G. 5

FIG. 6

F I G. 7

F I G. 8

# INTERNATIONAL SEARCH REPORT

International Application No  PCT/JP90/00051

## I. CLASSIFICATION OF SUBJECT MATTER (if several classification symbols apply, indicate all) 6

According to International Patent Classification (IPC) or to both National Classification and IPC

Int. Cl⁵  G06F3/023

## II. FIELDS SEARCHED

### Minimum Documentation Searched 7

| Classification System | Classification Symbols |
|---|---|
| IPC | G06F3/023 |

Documentation Searched other than Minimum Documentation
to the Extent that such Documents are Included in the Fields Searched 8

| | |
|---|---|
| Jitsuyo Shinan Koho | 1926 - 1989 |
| Kokai Jitsuyo Shinan Koho | 1971 - 1989 |

## III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| Y | JP, A, 62-209609 (Alps Electric Co., Ltd.), 14 September 1987 (14. 09. 87), (Family: none) | 1 - 8 |
| Y | JP, A, 62-173514 (Fujitsu Ltd.), 30 July 1987 (30. 07. 87), (Family: none) | 3 - 8 |
| Y | JP, A, 61-107418 (Sony Corporation), 26 May 1986 (26. 05. 86), (Family: none) | 1 - 8 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance: the claimed invention cannot be considered novel or cannot be considered to involve an inventive step

"Y" document of particular relevance: the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| March 19, 1990 (19. 03. 90) | April 2, 1990 (02. 04. 90) |
| International Searching Authority | Signature of Authorized Officer |
| Japanese Patent Office | |

Form PCT ISA/210 (second sheet) (January 1985)